# EUROPEAN PATENT APPLICATION

(11) **EP 1 191 609 A2**
(43) Date of publication of application: **27.03.2002**
(21) Application number: 01308136.9
(22) Date of filing: 25.09.2001
(51) Int. Cl.: H01L 33/00

(54) **LED lamp, LED lamp assembly and fixing method of an LED lamp**

(30) Priority: 26.09.2000 JP 2000291908
(71) Applicant: Kabushiki Kaisha Toshiba, Tokyo 105-8001 (JP)
(72) Inventor: Takahashi, Nozomu, c/o Intellectual Property Div., Minato-ku, Tokyo 105-8001 (JP); Kawasaki, Hitoshi, c/o Intellectual Property Div., Minato-ku, Tokyo 105-8001 (JP)
(74) Representative: Granleese, Rhian Jane

(57) **Abstract**

An LED lamp assembly according to one embodiment of the present invention comprises a first lead (2), an LED chip (1) mounted on the first lead (2), a second lead (3) electrically connected to the LED chip (1), a sealant (4) for sealing the LED chip (1) and portions of the first and second leads (2, 3), the first and second leads (2, 3) including first areas sealed with the sealant (4) and second areas exposed from the sealant (4), a metal plate (7) fixed to at least one of the second areas of the first and second leads (2, 3), and a pin (8) for fixing the at least one of the second areas of the first and second leads (2, 3) and the metal plate (7), wherein a first hole (6) is provided on the at least one of the second areas of the first and second leads (2, 3), a second hole (9) is provided in an area of the metal plate (7) opposite to the first hole (6), and the pin (8) is inserted in the first hole (6) and the second hole (9).

## Description

The present invention relates to a light-emitting diode (LED), an LED lamp assembly and a fixing method of an LED lamp, and particularly an LED lamp of low heat resistance structure, and an LED lamp assembly in which this LED lamp is fixed to a base metal plate.

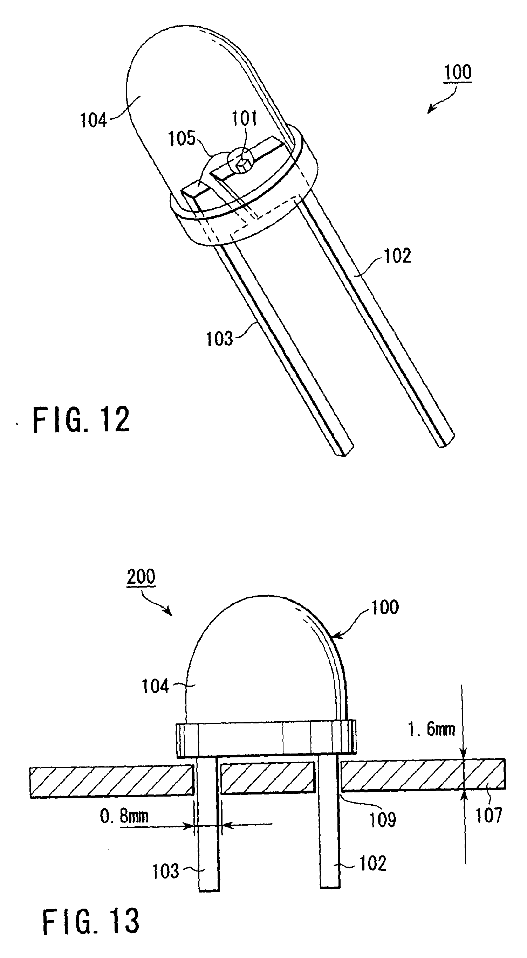

FIG. 12 is a perspective view of an LED lamp according to the prior art. As shown in FIG. 12, an LED lamp 100 according to the prior art has an LED chip 101 mounted on a lead for mount 102, and an electrode of the LED chip 101 is connected to a lead for bonding 103 using a bonding wire 105. The LED chip 101, bonding wire 105, a portion of lead for mount 102, and a portion of lead for bonding 103 are sealed with a transparent resin 104. Here, the diameter ø of the lead for mount 102 and lead for bonding 103 is, for example, about 0.3 to 0.6 mm.

FIG. 13 shows a cross-sectional view of an LED lamp assembly according the related art. As shown in FIG. 13, the lead for mount 102 and the lead for bonding 103 of the LED lamp 100 are inserted into a hole 109 of a printed board 107, and the periphery of this hole 109 is soldered. Here, the thickness of the printed board 107 is, for example, 1.6 µm, and the diameter ø of the hole 109 is, for example, 0.8 µm. Thereby, the LED lamp 100 is fixed mechanically and electrically to the printed board 107 to form an LED lamp assembly 200.

However, in the above conventional LED lamp assembly 200, heat is generated during the soldering, and this heat is absorbed in the transparent resin 104. Thereby, the transparent resin 104 is softened or heat expanded, the LED chip 101 is stressed, or other problems have occurred.

In addition, according to the increase of brightness of the LED lamp 100 in recent years, a bulb by a high current driving is required. Under such a requirement, it becomes necessary to dissipate effectively the heat generation due to the electric conduction. There, the heat generation from the LED chip 101 has been released outside effectively, by making thick the leads 102, 103 of the conventional LED lamp 100. However, in such LED lamp 100, the heat absorption amount of the transparent resin 104 is more than a generally used LED lamp 100, during the soldering. As a result, the problem of stress applied to the LED chip 101 described above becomes evident, thereby deteriorating the reliability of the product.

An LED lamp according to a first aspect of the present invention comprises: a first lead; an LED chip mounted on the first lead; a second lead electrically connected to the LED chip; and a sealant for sealing the LED chip and portions of the first and second leads; wherein the first and second leads comprise first areas sealed with the sealant and second areas exposed from the sealant, and a hole is provided on at least one of the second areas of the first and second leads.

An LED lamp assembly according to a second aspect of the present invention comprises: a first lead; an LED chip mounted on the first lead; a second lead electrically connected to the LED chip; and a sealant for sealing the LED chip and portions of the first and second leads, the first and second leads comprising first areas sealed with the sealant and second areas exposed from the sealant; a metal plate fixed to at least one of the second areas of the first and second leads; and a pin for fixing the metal plate and at least one of the second areas of the first and second leads, wherein a first hole is provided in at least one of the second areas of the first and second leads, a second hole is provided in an area of the metal plate opposite to the first hole, and the pin is inserted in the first hole and the second hole.

A fixing method of an LED lamp according to a third aspect of the present invention comprises: mounting an LED chip on a first lead, and connecting electrically a second lead with the LED chip; sealing the LED chip and portions of the first and second leads with a sealant; and inserting a pin in a first hole of the first lead and a second hole of a metal plate, expanding outward and crashing a shaft portion of the pin by press-fitting the first lead and the metal plate in the up and down direction of the pin, and fixing the first lead and the metal plate by the pin.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a perspective view showing an LED lamp according to a first embodiment of the present invention;
FIG. 2 is a perspective view showing an LED lamp assembly according to the first embodiment of the present invention;
FIG. 3 is a perspective view showing a state of inserting a fixing pin into a lead and a base metal;
FIG. 4A is a cross section view showing an adhesion step of the LED lamp according to the first embodiment of the present invention;
FIG. 4B is a cross section view showing an adhesion step of the LED lamp according to the first embodiment of the present invention, following FIG. 4A;
FIG. 4C is a cross section view showing an adhesion step of the LED lamp according to the first embodiment of the present invention, following FIG. 4B;
FIG. 5 is a graph showing a comparative example of optical output for a current of a conventional LED lamp and the LED lamp of embodiments of the present invention;
FIG. 6A is a cross section view showing an adhesion step of an LED lamp according to a second embodiment of the present invention;
FIG. 6B is a cross section view showing an adhesion step of the LED lamp according to the second embodiment of the present invention, following FIG. 6A;
FIG. 7A is a cross section view showing an adhesion step of an LED lamp according to a third embodiment of the present invention;
FIG. 7B is a cross section view showing an adhesion step of the LED lamp according to the third embodiment of the present invention, following FIG. 7A;
FIG. 8A is a cross section view showing an adhesion step of an LED lamp according to a fourth embodiment of the present invention;
FIG. 8B is a cross section view showing an adhesion step of the LED lamp according to the fourth embodiment of the present invention, following FIG. 8A;
FIG. 9 is a plan view showing the shape of a hole of a lead and a base metal according to a fifth embodiment of the present invention;
FIG. 10A is a plan view showing the shape of a fixing pin according to a sixth embodiment of the present invention;
FIG. 10B is a cross section view of an LED assembly according to the sixth embodiment of the present invention;
FIG. 11A is a plan view showing the shape of another fixing pin according to the sixth embodiment of the present invention;
FIG. 11B is a side view showing the shape of another fixing pin according to the sixth embodiment of the present invention;
FIG. 12 is a perspective view showing an LED lamp according to the prior art; and
FIG. 13 is a cross section view of an LED assembly according to the prior art.

Now, embodiments of the present invention will be described referring to the drawings.

### [First embodiment]

In a first embodiment, a first hole is proved in a lead of a light-emitting diode (LED) lamp, a second hole is provided on a base metal opposite to this first hole, and a fixing pin is inserted in the first and second holes to adhere the lead and the base metal.

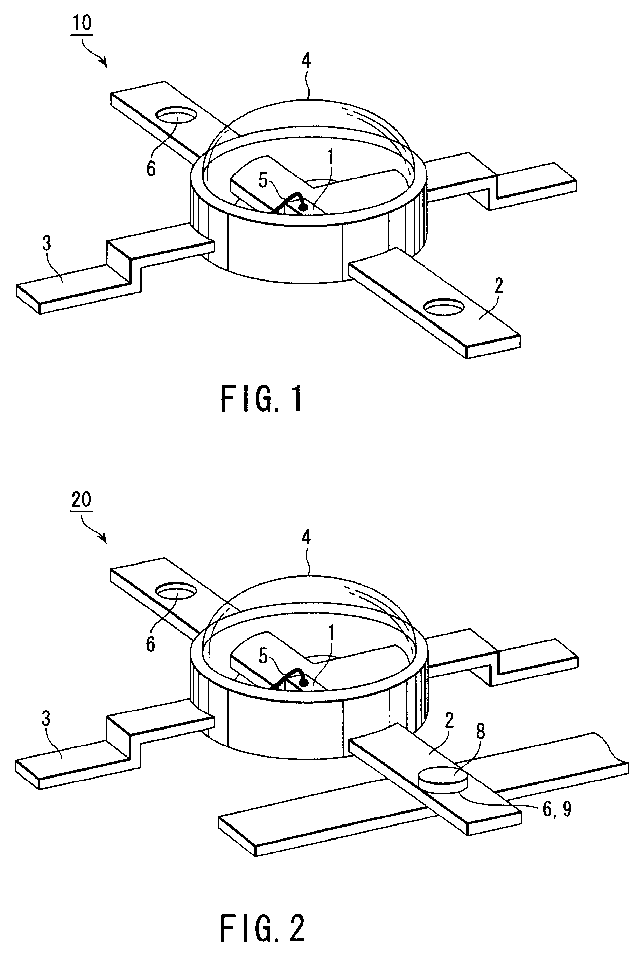

FIG. 1 is a perspective view showing an LED lamp according to the first embodiment of the present invention. As shown in FIG. 1, in an LED lamp 10 according to the first embodiment, an LED chip 1 is mounted on a lead for mount 2, and an electrode of this LED chip 1 is connected to a lead for bonding 3 using a bonding wire 5. The LED chip 1, bonding wire 5, a portion of the lead for mount 2, and a portion of the lead for bonding 3 are sealed with a sealing transparent resin 4. Here, the sealant is not limited to the transparent resin, but for example, it may be metal, glass or the like.

In addition, a concentric circular through hole 6 of, for example, 1.3 mm in diameter ø is provided, on a face exposed from the sealing transparent resin 4 for lead for mount 2. The hole 6 may be provided not only on the lead for mount 2 but also on the lead for bonding 3, and may be provided at least on one of the lead for mount 2 and the lead for bonding 3. Besides, the hole 6 may, for example, be hexagonal, and is not limited to a concentric circular shape.

FIG. 2 is a perspective view showing an LED lamp assembly according to the first embodiment of the present invention. As shown in FIG. 2, a base metal 7 is adhered to the lead for mount 2 of the aforementioned LED lamp with a fixing pin 8. Here, a concentric circular through hole 9 of, for example, 1.3 mm in diameter ø is provided in an area opposite to the hole 6 of the lead for mount 2 in the base metal 7. When a hole is provided on the lead for bonding 3, the base metal 7 is also adhered to the lead for bonding 3 with the fixing pin 8. Besides, the hole 9 may, for example, be hexagonal, and is not limited to a concentric circular shape.

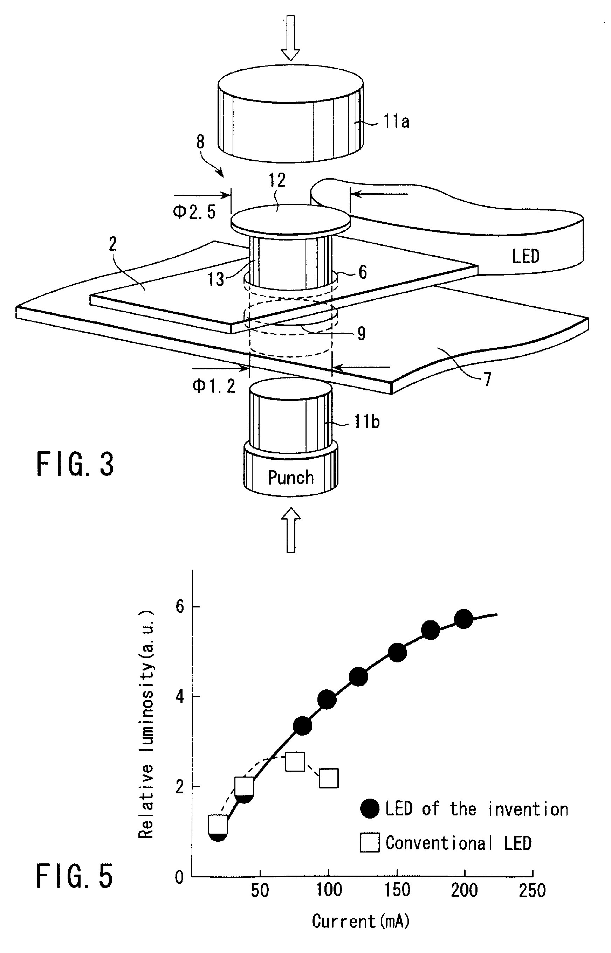

FIG. 3 shows a state of inserting a fixing pin into a lead and a base metal. As shown in FIG. 3, the fixing pin 8 is inserted from the hole 6 of the lead for mount 2 into the hole 9 of the base metal 7. Then, the lead for mount 2 and the base metal 7 are adhered by press-fitting from above and under direction of the fixing pin 8, using jigs 11a, 11b such as Punch. The detail of this adhesion method will be described below. The diameter ø of a head portion 12 of the fixing pin 8 is, for example, 2.5 mm, and the diameter ø of a shaft portion 13 of the fixing pin 8 is, for example, 1.2 mm.

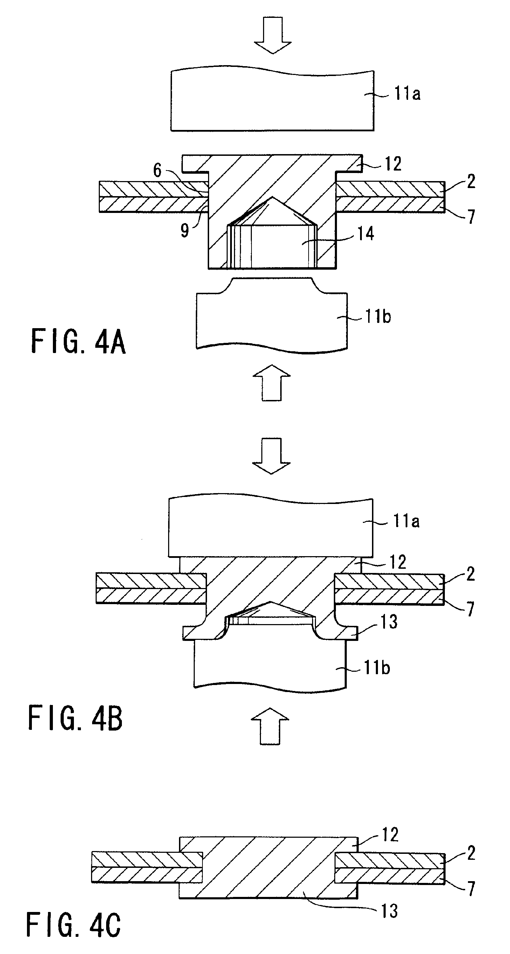

FIG. 4A to FIG. 4C show side views of an adhesion step of the LED lamp. Now, an adhesion method of the LED lamp according to the first embodiment will be explained. Though FIG. 4A to FIG. 4C show an example of adhering the base metal 7 and the lead for mount 2, in case of adhering the base metal 7 and the lead for bonding 3 also, they are adhered by a similar method.

First, as shown in FIG. 4A, a fixing pin 8 is inserted from the hole 6 of the lead for mount 2 into the hole 9 of the base metal 7. Next, the base metal 7 and the lead for mount 2 are pinched and adhered by press-fitting from above and under direction of the fixing pin 8 using jigs 11a, 11b. Here, as the diameter of the head portion 12 of the fixing pin 8 is larger than those of the holes 6, 9, the head portion 12 of the fixing pin 8 is configured to be fixed on the surface of the lead for mount 2, during the press-fitting. In addition, a hollow portion 14 is provided at the middle in the shaft portion 13 of the fixing pin 8, and a boss having a diameter slightly smaller than that of the hollow portion 14 is provided in the jig 11b.

Next, when the press-fitting is advance by the jigs 11a, 11b as shown in FIG. 4B, the head portion 12 of he fixing pin 8 is fixed on the surface of the lead for mount 2. At the same time, the boss of the jig 11b is inserted into the hollow portion 14 and pressure adhered, thereby the shaft portion 13 of the fixing pin 8 is expanded outward. Then, the shaft portion 13 of the fixing pin 8 expanded outward is crashed, in a way to sandwich the lead for mount 2 and the base metal 7, by further applying a pressure from above and under direction of the fixing pin 8.

As a result, as shown in FIG. 4C, the hollow portion 14 of the fixing pin 8 disappears, and the lead for mount 2 and the base metal 7 are adhered.

According to the above first embodiment, the holes 6, 9 are provided on the lead for mount 2 and the base metal 7, and the fixing pin 9 is inserted into these holes 6, 9 and crashed. Thereby, the lead for mount 2 for the LED lamp 10 is connected mechanically and electrically to the base metal 7. Therefore, the lead for mount 2 and the base metal 7 can be made into contact over a large area. Therefore, the radiation from the LED lamp 10 at the leads 2, 3 can be enhanced, and heat generated when the LED lamp 10 is turned on can be released effectively outside. As a result, the current can be increased more than the conventional LED lamp, and the LED lamp 10 can be driven with a high current.

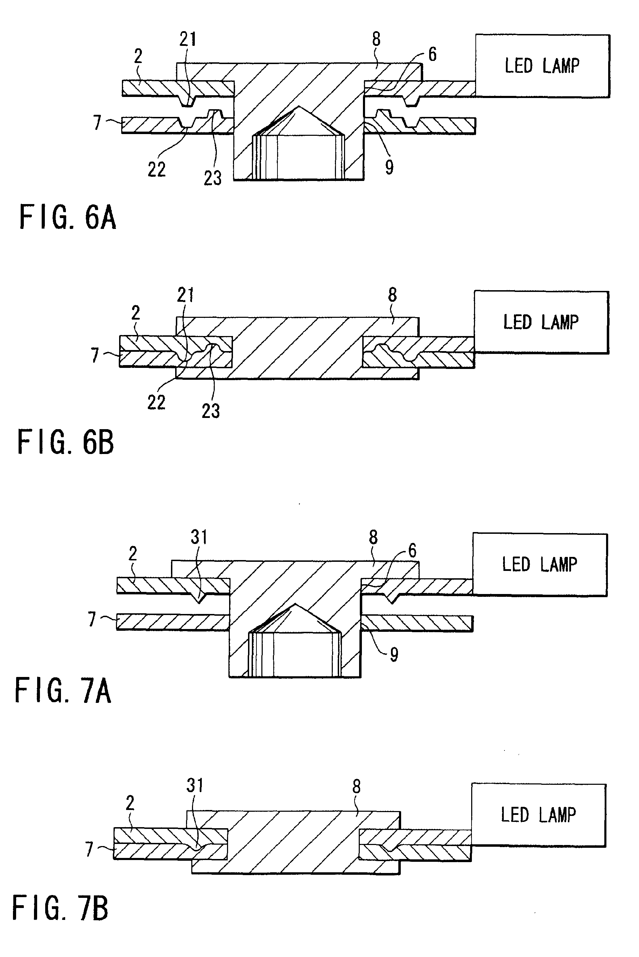

FIG. 5 shows a graph of a comparative example of optical output for a current of a conventional LED lamp and the LED lamp of the present invention. As shown in FIG. 5, the optical output of the conventional LED lamp lowers around 70 mA, while the optical output of the LED lamp of the present invention increases up to around 200 mA. Thus, according to the first embodiment of the present invention, the optical output of the LED lamp can be multiplied by about 3 times of the conventional one, allowing to realize an LED lamp with high brightness.

Note that, according to the first embodiment of the present invention, the LED lamp is fixed using the fixing pin 9. In short, it is needless to say that the problem of increase of heat absorption quantity of the transparent resin 4 as in the related art will not occur, because the soldering is not performed.

### [Second Embodiment]

The second embodiment is an example wherein an uneven section is provided around respective holes in the lead of the base metal and the LED lamp. In the second embodiment, the description of the structure and the adhesion method similar to the aforementioned first embodiment will be omitted, and only different structure and adhesion method shall be described.

FIG. 6A and FIG. 6B show the side view of an adhesion step of the LED lamp according to the second embodiment of the present invention.

In an LED lamp assembly according to the second embodiment, as shown in FIG. 6A, at least one or more boss 21 is provided around the hole 6 of the lead for mount 2. In addition, a recess 22 is provided in an area corresponding to the boss 21, around the hole 9 of the base metal 7, and at least one or more boss 23 is provided in an area between this recess 22 and the hole 9.

It is preferable that the height of the boss 21 of the lead for mount 2 is larger than the depth of the recess 22 of the base metal 7. Also, the recess may be provided in an area corresponding to the boss 23 around the hole 6 of the lead for mount 2.

Next, an adhesion method of the LED lamp according to the second embodiment will be described. First, as shown in FIG. 6A, the fixing pin 8 is inserted into the hole 9 of the base metal 7 through the hole 6 of the lead for mount 2. Next, when pressure adhered by jigs (not shown) from above and under direction of the fixing pin 8, the boss 21 of the lead for mount 2 is inserted into the recess 22 of the base metal 7. Applying an additional pressure, as shown in FIG. 6B, the boss 21 of the lead for mount 2 and the recess 22 of the base metal 7 are crashed, and the recess 22 of the base metal 7 is buried by this crashed boss 21 of the lead for mount 2. In this way, the lead for mount 2 and the base metal 7 are adhered.

According to the aforementioned second embodiment, effects similar to the first embodiment can be obtained.

Further, in the adhesion of the LED lamp, the adhesion between the lead for mount 2 and the base metal 7 can be enhanced, because the uneven sections 21, 22, 23 deform when the pressure is applied.

### [Third Embodiment]

A third embodiment is an example of providing a boss around the hole of the lead of the LED lamp. It should be appreciated that, in the third embodiment, the description of the structure and the adhesion method similar to the aforementioned first embodiment will be omitted, and only different structure and adhesion method shall be described.

FIG. 7A and FIG. 7B show side views of an adhesion step of the LED lamp according to the third embodiment of the present invention.

In an LED lamp assembly according to the third embodiment, as shown in FIG. 7A, at least one or more boss 31 is provided around the hole 6 of the lead for mount 2. It is preferable that the tip of this boss 31 is acute. Besides, the recess 31 may be provided around the hole 6 of the base metal 7, and it is enough that it is provided on at least one of the lead for mount 2 and the base metal 7.

Next, an adhesion method of the LED lamp according to the third embodiment will be described. First, as shown in FIG. 7A, the fixing pin 8 is inserted into the hole 9 of the base metal 7 through the hole 6 of the lead for mount 2. Next, when pressure adhered by jigs (not shown) from above and under direction of the fixing pin 8, as shown in FIG. 7B, the boss 31 of the lead for mount 2 is crashed. In this way, the lead for mount 2 and the base metal 7 are adhered.

According to the aforementioned third embodiment, effects similar to the first embodiment can be obtained.

Further, in the adhesion of the LED lamp, the adhesion between the lead for mount 2 and the base metal 7 can be enhanced, because the boss 31 deforms when the pressure is applied.

### [Fourth Embodiment]

A fourth embodiment is an example wherein the lead ant the base metal of the LED lamp has a conical shape. In the fourth embodiment, the description of the structure and the adhesion method similar to the aforementioned first embodiment will be omitted, and only different structure and adhesion method shall be described.

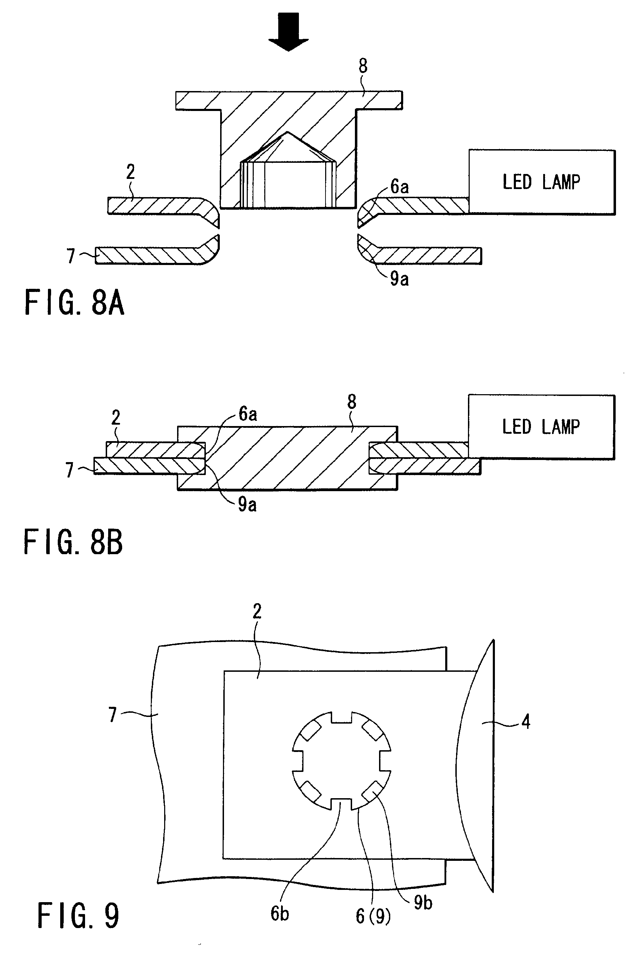

FIG. 8A and FIG. 8B show side views of an adhesion step of the LED lamp according to the fourth embodiment of the present invention.

In an LED lamp assembly according to the fourth embodiment, as shown in FIG. 8A, the hole 6a of the lead for mount 2 and the hole 9a of the base metal 7 have a conical shape like an earthenware mortar. Here, it is preferable that the shape of the hole 6a of the lead for mount 2 is conical in a way to reduce the diameter of the hole at the side of a contact surface with the base metal 7, and the hole 9a of the base metal 7 be conical in a way to increase the diameter of the hole at the side of a contact surface with the lead for mount 2. The conical shape like an earthenware mortar may be applied to at least one of the lead for mount 2 and the base metal 7.

Next, an adhesion method of the LED lamp according to the fourth embodiment will be described. First, as shown in FIG. 8A, the fixing pin 8 is inserted into the hole 9 of the base metal 7 through the hole 6 of the lead for mount 2. Next, when pressure adhered by jigs (not shown) from above and under direction of the fixing pin 8, the hole 6a of the lead for mount 2 and the hole 9a of the base metal 7 are crashed and come into a close contact, and the lead for mount 2 and the base metal 7 are adhered.

According to the above fourth embodiment, effects similar to the first embodiment can be obtained.

Further, the adhesion between the lead for mount 2 and the base metal 7 can be enhanced by the conical holes 6a, 9a in the lead for mount 2 and the base metal 7, and the lead for mount 2 and the base metal 7 fit better with the fixing pin 8.

### [Fifth Embodiment]

A fifth embodiment is an example wherein the hole of the lead and the base metal of the LED lamp is a shape having a boss.

In the fifth embodiment, the description of the structure and the adhesion method similar to the aforementioned first embodiment will be omitted, and only different structure and adhesion method shall be described.

FIG. 9 shows a plan view of the hole of the lead and the base metal according to the fifth embodiment of the present invention. As shown in FIG. 9, bosses 6b, 9b projecting toward the centers of the holes 6, 9 are provided in the hole 6 of the lead for mount 2 and in the hole 9 of the base metal 7. Here, the boss 6b of the lead for mount 2 and the boss 9b of the base metal 7 are provided without overlapping. The boss of the hole may be provided in at least one of the lead for mount 2 and the base metal 7.

According to the above fifth embodiment, effects similar to the first embodiment can be obtained.

Further, the bosses 6b, 9b are provided in the holes 6, 9 of the lead for mount 2 and the base metal 7. Thereby, in the adhesion of the lead for mount 2 and the base metal 7, the bosses 6,b, 9b of the holes 6, 9 come into contact strongly to the fixing pin, enhancing the fitting and the contact of the lead for mount 2 and the base metal 7 with the fixing pin.

### [Sixth Embodiment]

A sixth embodiment is an example wherein the diameter of the shaft portion of the fixing pin is increased from the tip to the root thereof, and a boss is provided at the shaft portion side face of the fixing pin. In the sixth embodiment, the description of the structure and the adhesion method similar to the aforementioned first embodiment will be omitted, and only different structure and adhesion method shall be described.

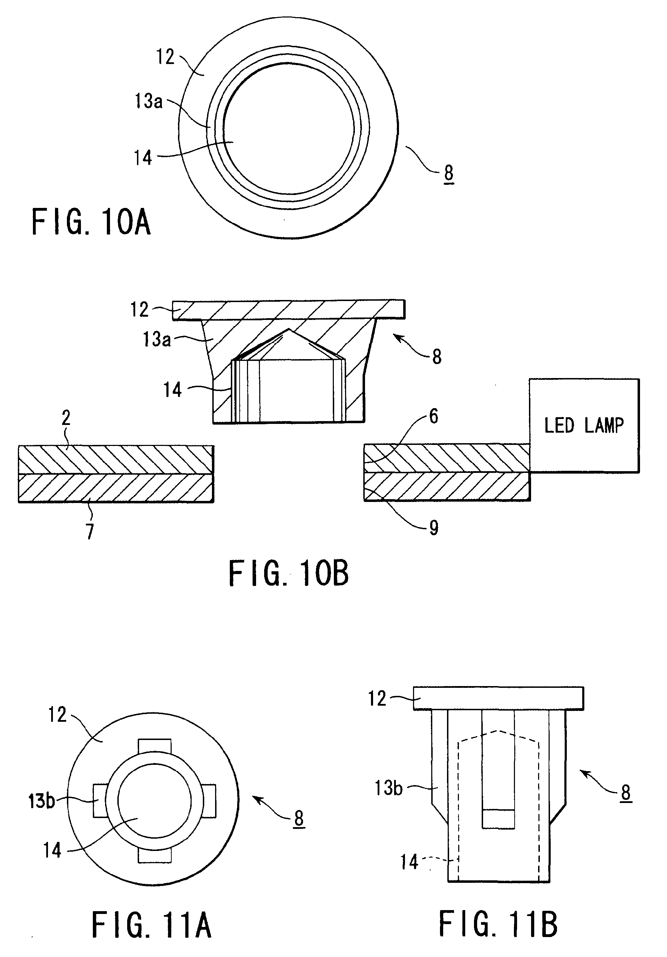

FIG. 10A shows a plan view of the fixing pin according to the sixth embodiment of the present invention. FIG. 10B shows a side view of an LED assembly according to the sixth embodiment of the present invention. As shown in FIG. 10A and FIG. 10B, the diameter of the shaft portion 13a of the fixing pin 8 becoming larger than the diameter of the hole 6, 9 from the tip to be inserted to the root (head portion 12 side). According to the structure of this fixing pin 8, when one try to insert the fixing pin 8 up to the root into the holes 6, 9 of the lead for mount 2 and the base metal 7, the fixing pin 8 is adhered during a gradual enlargement of the holes 6, 9 by the shaft portion of the fixing pin 8 of large diameter. Consequently, a close contact between the lead for mount 2 and the base metal 7 is enhanced, and the fitting force between the lead for mount 2 and the base metal 7 and the fixing pin 8 is increased.

FIG. 11A shows a plan view of another fixing pin according to the sixth embodiment. FIG. 11B shows a side view of another fixing pin according to the sixth embodiment. As shown in FIG. 11A and FIG. 11B, for example, a cruciform boss 13b is provide on the shaft portion 13 of the fixing pin 8. It is preferable that the height of this boss 13b is lower at the tip than at the root (head portion 12 side), and the boss 13b of the root is larger than the diameter of the holes 6, 9. According to the structure of this fixing pin 8, when it is intended to insert the fixing pin 8 up to the root into the holes 6, 9 of the lead for mount 2 and the base metal 7, the fixing pin 8 is adhered during a gradual enlargement of the hole 6, 9 by the boss 13b of the fixing pin 8. Consequently, a close contact between the lead for mount 2 and the base metal 7 is enhanced, and the fitting force between the lead for mount 2 and the base metal 7 and the fixing pin 8 is increased.

According to the above sixth embodiment, effects similar to the first embodiment can be obtained.

Further, a close contact between the lead for mount 2 and the base metal 7 is enhanced, and the fitting force between the lead for mount 2 and the base metal 7 and the fixing pin 8 can be is increased.

The adhesion structure and the adhesion method of the present invention are not limited to the LED lamp, but they can be applied to various semiconductor devices.

## Claims

1. An LED lamp, **characterized by** comprising:
a first lead (2);
an LED chip (1) mounted on said first lead (2);
a second lead (3) electrically connected to said LED chip (1); and
a sealant (4) for sealing said LED chip (1) and portions of said first and second leads (2, 3), wherein
said first and second leads (2, 3) comprise first areas sealed with said sealant (4) and second areas exposed from said sealant (4), and a hole (6) is provided on at least one of said second areas of said first and second leads (2, 3).

2. The LED lamp according to claim 1, **characterized in that** an uneven section (21) is provided around said hole (6) of the at least one of said first and second leads (2, 3).

3. The LED lamp according to claim 1, **characterized in that** an acute boss (31) is provided around said hole (6) of the at least one of said first and second leads (2, 3).

4. The LED lamp according to claim 1, **characterized in that** said hole (6a) of the at least one of said first and second leads (2, 3) has a conical shape.

5. The LED lamp according to claim 1, **characterized in that** a boss (6b) projecting toward a center of said hole (6) is provided around said holes (6) of the at least one of said first and second leads (2, 3).

6. An LED lamp assembly, **characterized by** comprising:
a first lead (2);
an LED chip (1) mounted on said first lead (2);
a second lead (3) electrically connected to said LED chip (1);
a sealant (4) for sealing said LED chip (1) and portions of said first and second leads (2, 3), said first and second leads (2, 3) comprising first areas sealed with said sealant (4) and second areas exposed from said sealant (4);
a metal plate (7) fixed to at least one of said second areas of said first and second leads (2, 3); and
a pin (8) for fixing the at least one of said second areas of said first and second leads (2, 3) and said metal plate (7), wherein,
a first hole (6) is provided on the at least one of said second areas of said first and second leads (2, 3), a second hole (9) is provided in an area of said metal plate (7) opposite to said first hole (6), and said pin (8) is inserted in said first hole (6) and said second hole (9).

7. The LED lamp assembly according to claim 6, **characterized in that** uneven sections (21, 22, 23) are provided around at least one of said first and second holes (6, 9) on a contacting face side of said metal plate (7) with the at least one of said first and second leads (2, 3).

8. The LED lamp assembly according to claim 6, **characterized in that** an acute boss (31) is provided around at least one of said first and second holes (6, 9) on a contacting face side of said metal plate (7) with the at least one of said first and second leads (2, 3).

9. The LED lamp assembly according to claim 6, **characterized in that** at least one of said first and second holes (6a, 9a) has a conical shape.

10. The LED lamp assembly according to claim 9, **characterized in that**
a diameter of said first hole (6a) on a contacting face side with said metal plate (7) is smaller than a diameter of said first hole (6a) on a side opposite to a contacting face with said metal plate (7), and
a diameter of said second hole (9a) on a contacting face side with the at least one of said first and second leads (2, 3) is larger than a diameter of said second hole (9a) on a side opposite to a contacting face with the at least one of said first and second leads (2, 3).

11. The LED lamp assembly according to claim 6, **characterized in that** bosses (6b, 9b) projecting toward centers of said first and second holes (6, 9) are provided around at least one of said first and second holes (6, 9).

12. The LED lamp assembly according to claim 11, **characterized in that** said boss (6b) of said first hole (6) and said boss (9b) of said second hole (9) do not overlap.

13. The LED lamp assembly according to claim 6, **characterized in that** said pin (8) comprises:
a head portion (12); and
a shaft portion (13) comprising a diameter smaller than a diameter of said head portion (12), a hollow portion (14) being provided in said shaft portion (13).

14. The LED lamp assembly according to claim 6, **characterized in that** said pin (8) comprises:
a head portion (12); and
a shaft portion (13a) comprising a diameter smaller than a diameter of said head portion (12), a hollow portion (14) being provided in said shaft portion (13a), said diameter of said shaft portion (13a) becoming longer than a diameter of said first and second holes (6, 9) according to an approach to said head portion (12) from a tip section to be inserted into said first and second holes (6, 9).

15. The LED lamp assembly according to claim 13, **characterized in that** a boss (13b) is provided on a side face of said shaft portion (13).

16. A fixing method of an LED lamp **characterized by** comprising:
mounting an LED chip (1) on a first lead (2), and connecting electrically a second lead (3) with said LED chip (1);
sealing said LED chip (1) and portions of said first and second leads (2, 3) with a sealant (4); and
inserting a pin (8) in a first hole (6) of said first lead (2) and a second hole (9) of a metal plate (7), expanding outward and crashing a shaft portion (13) of said pin (8) by press-fitting said first lead (2) and said metal plate (7) in up and down directions of said pin (8), and fixing said first lead (2) and said metal plate (7) by said pin (8).

17. The fixing method of an LED lamp according to claim 16, **characterized in that**
said second lead (3) comprises a third hole; and
said pin (8) is inserted into said third hole and said second hole (9), and said second lead (3) and said metal plate (7) is fixed by said pin (8).

18. The fixing method of an LED lamp according to claim 16, **characterized in that**
uneven sections (21, 22, 23) are provided, around at least one of said first and second holes (6, 9) of a contacting face side of said metal plate (7) and said first lead (2); and
said uneven sections (21, 22, 23) are crashed for fixing said first lead (2) and said metal plate (7) by said pin (8).

19. The fixing method of an LED lamp according to claim 16, **characterized in that**
an acute boss (31) is provided around at least one of said first and second holes (6, 9) of a contacting face side of said metal plate (7) and said first lead (2); and
said boss (31) is crashed to fix said first lead (2) and said metal plate (7) by said pin (8).

20. The fixing method of an LED lamp according to claim 16, **characterized in that**
at least one of said first and second holes (6a, 9a) comprises a conical shape; and
said first and second holes (6a, 9a) are crashed to fix said first lead (2) and said metal plate (7) by said pin (8).

21. The fixing method of an LED lamp according to claim 16, **characterized in that**
bosses (6b, 9b) projecting toward centers of said first and second holes (6, 9) are provided around at least one of said first and second holes (6, 9); and
said bosses (6b, 9b) are crashed to fix said first lead (2) and said metal plate (7) by said pin (8).

22. The fixing method of an LED lamp according to claim 16, **characterized in that**
said pin (8) comprises a head portion (12), and a shaft portion (13a) comprising a diameter smaller than a diameter of said head portion (12),
said diameter of said shaft portion (13a) becomes longer than a diameter of said first and second holes (6, 9) according to an approach to said head portion (12) from a tip section to be inserted into said first and second holes (6, 9), and
during the press-fitting, said first and second holes (6, 9) are enlarged gradually by said shaft portion (13a) to fix said first lead (2) and said metal plate (7) by said pin (8).

23. The fixing method of an LED lamp according to claim 16, **characterized in that**
said pin (8) comprises a head portion (12) and a shaft portion (13) comprising a diameter smaller than a diameter of said head portion (12) and provided with a boss (13b) on a side face thereof; and
said boss (13b) is crashed to fix said first lead (2) and said metal plate (7) by said pin (8).
